# EUROPÄISCHE PATENTSCHRIFT

(11) **EP 1 114 979 B1**
(45) Veröffentlichungstag und Bekanntmachung des Hinweises auf die Patenterteilung: **16.03.2005**
(21) Anmeldenummer: 00124279.1
(22) Anmeldetag: 14.11.2000
(51) Int. Cl.: G01B 11/06, G01N 21/21, G03F 9/00

(54) **Entkoppelte Wafer Neigungsmessung an Ellipsometer mit Spektralphotometer und Fokusmessung durch Spiegelobjectiv**
Uncoupled wafer inclination measurement with an ellipsometer with spectral photometer and measurement of focus by a reflecting objective
Mesure découplée d'inclinaison d'une rondelle avec un ellipsomètre avec photomètre spectral et mesure du foyer par un objectif à réflecteurs

(30) Priorität: 27.12.1999 DE 19963345
(43) Veröffentlichungstag der Anmeldung: 11.07.2001
(73) Patentinhaber: Leica Microsystems Jena GmbH, 07745 Jena (DE)
(72) Erfinder: Hallmeyer, Klaus, 07768 Kahla (DE); Hoffmann, Günter, 07743 Jena (DE); Wienecke, Joachim, 07747 Jena (DE)
(74) Vertreter: Reichert, Werner F., Dr.

(56) Entgegenhaltungen:
- WO-A-98/22801
- DE-U- 29 815 297
- FR-A- 2 680 240
- US-A- 4 130 757
- US-A- 5 608 526
- US-A- 5 715 061

## Beschreibung

Die Erfindung betrifft optische Messenordnungen und ein Verfahren zur Messung der Neigung-Unabhängige Ansprüche 1,4,6,10.

Die Erfindung bezieht sich auf eine optische Meßanordnung mit einem Ellipsometer, bei dem ein Einfallstrahl polarisierten Lichtes unter einem Winkel α≠90° auf einen Meßort an der Oberfläche einer Probe gerichtet ist und aus der Untersuchung des reflektierten Ausfallstrahles Hinweise auf Probeneigenschaften, bevorzugt auf Schichtdicken, gewonnen werden, und mit einer Einrichtung zur Ermittlung und Korrektur von Richtungsabweichungen zwischen der Normalen auf die Probenoberfläche und der Winkelhalbierenden zwischen Ein- und Ausfallstrahl. Die Erfindung bezieht sich weiterhin auf eine Meßanordnung und ein Verfahren mit einem Objektiv zur Beleuchtung und Abbildung eines Meßortes auf einer Probe und einer Nivelliereinrichtung mit einer optischen Strahlungsquelle, einem Richtungskontrollstrahl und einem ortsauflösenden Detektor.

Optische Meßanordnungen nach dem Prinzip von Ellipsometern und Spektralphotometern sowie deren Verwendung zur Schichtdickenmessung sind aus dem Stand der Technik bekannt. Ihr Einsatz hat sich insbesondere bei der Messung dünner Schichten, beispielsweise an den Strukturen von Waferoberflächen, bewährt.

Da insbesondere bei der Waferherstellung immer feinere Strukturen und immer dünnere Schichten angestrebt werden, werden auch an die Genauigkeit der optischen Meßanordnungen, mit denen die Maßhaltigkeit der Strukturen und Schichten nachgewiesen wird, immer höhere Anforderungen gestellt. Dabei ist nicht nur darauf zu achten, daß keine Kanten der Strukturen im Meßfenster liegen, weil dadurch die Schichtdickenmessung verfälscht würde, sondern es muß vor allem auch gewährleistet sein, daß die Probenoberfläche an der Meßstelle senkrecht zum Meßstrahlengang ausgerichtet ist, damit Meßfehler ausgeschlossen werden können.

Schieflagen bzw. unerwünschte Neigungen der Probenoberfläche ergeben sich beispielsweise, wenn die Probe selbst eine unebene Oberfläche aufweist, nicht neigungsfrei auf dem Probentisch aufliegt oder durch Ansaugung auf die Auflagefläche verspannt wird. Es ist also notwendig, solche Schieflagen zu ermitteln und durch geeignete Stellsysteme auszugleichen. Weiterhin setzt eine genaue Messung auch eine präzise Fokussierung voraus, d.h. es muß sichergestellt sein, daß die Probenoberfläche in der Fokusebene liegt bzw. bei Abweichungen die Probe entsprechend justiert werden kann.

Um auch komplizierte Strukturen und Schichtsysteme vermessen zu können, werden häufig sowohl Ellipsometer als auch Spektralphotometer in einer gemeinsamen Anordnung zur Messung genutzt. Dabei erzielt man zwar eine hohe Meßsicherheit, jedoch führt die Vielzahl der erforderlichen optischen Baugruppen zu Platzproblemen, da diese so aufeinander abzustimmen und zueinander zu positionieren sind, daß sich die Strahlengänge nach Möglichkeit nicht wesentlich beeinflussen. In der Regel ist zum Beispiel der direkte Zugang zum Meßort bereits durch das Meßobjektiv des Spektralphotometers verdeckt.

Weitere Probleme ergeben sich auch aufgrund der variablen Meßorte auf der Probenoberfläche, d.h. es erfolgt während der Messung oder auch zwischen einzelnen Meßschritten eine Positionsveränderung der Probe relativ zu den Meßstrahlengängen, was bei unzureichender Präzision der dazu vorgesehenen mechanischen Stelleinrichtungen zur Defokussierung und auch zur Verkippung der Probenoberfläche führen kann.

Weil neben der Forderung nach höherer Genauigkeit auch das Bestreben nach wachsenden Produktionsstückzahlen berücksichtigt werden muß, ist es beispielsweise bei der kontinuierlichen Fertigung von Wafern erforderlich, in immer kürzer werdenden Abständen zu messen und dabei vor jeder Messung zu prüfen, ob die Voraussetzungen für die geforderte hohe Meßgenauigkeit gegeben sind. Ist dies nicht der Fall, muß dieser Prüfung eine schnelle und nach Möglichkeit selbsttätige Korrektur der Probenausrichtung folgen.

Im Stand der Technik ist bereits eine Vielzahl von Veröffentlichungen zur Ausrichtung von Wafern in Wafersteppern bzw. zur Nivellierung relativ zum Meßstrahlengang bekannt. So wird beispielsweise in der US-Patentschrift 4,398,824 ein Verfahren zur Ausrichtung eines Wafers beschrieben, bei dem lokale Schieflagen des Wafers und Ungleichmäßigkeiten des Photoresists ausgeglichen werden können. Die Anwendung dieses Verfahrens ist aber nur dann möglich, wenn Teile des Wafers als Fresnelzonen ausgebildet sind. Da dies aber regelmäßig nicht der Fall ist, ist das hier vorgeschlagene Verfahren für die häufigsten Einrichtungen der Waferfertigung nicht geeignet.

In der US-Patentschrift 5,218,415 ist ein Gerät zur Bestimmung der Schieflage eines Wafers relativ zum Meßstrahlengang beschrieben, bei dem eine Anordnung zur Beleuchtung eines Meßortes auf dem Wafer, eine Einrichtung zum Empfang des reflektierten Lichtstrahles und Mittel zur Veränderung der Größe des Lichtstrahles vorgesehen sind. Hierbei wird die Größe bzw. der Querschnitt des Lichtstrahles in der optisch konjugierten Ebene der zu messenden Oberfläche bestimmt.

Die US-Patentschrift 4,595,829 offenbart eine Anordnung zur Fokussierung einer Probenoberfläche, mit der es möglich ist, die Fokusebene zu bestimmen und die Veränderung der Lage der Probe so zu veranlassen, daß die Probenoberfläche in der Fokusebene liegt. Die Ermittlung und Korrektur einer Verkippung der Probenoberfläche relativ zum Meßstrahlengang ist mit dieser Anordnung jedoch nicht möglich, so daß die Voraussetzungen für genaueste Messungen nicht geschaffen werden können.

In der US-Patentschrift 5,136,149 ist ein Verfahren zur Inspektion von Waferoberflächen beschrieben, mit dem sowohl eine Fokussierung als auch Bestimmung der Schieflage der Waferoberfläche möglich ist. Hier wird ein Strahlengang durch ein Objektiv auf die Probenoberfläche gerichtet und das dort reflektierte Licht in zwei Strahlengänge aufgeteilt. Davon wird der erste Strahlengang von einem positionsempfindlichen Zeilenempfänger (CCD-Zeile) registriert und mit Hilfe dieses Empfängers ein Fokussignal generiert. Der zweite Teilstrahl trifft auf einen zweidimensionalen positionsempfindlichen Empfänger und wird hier zur Bestimmung der Schieflage genutzt. Ein wesentlicher Nachteil hierbei besteht darin, daß die Bestimmung von Fokus- und Schieflage und damit auch die Nachstellmöglichkeiten bei der Korrektur von Fokus- und Schieflage nicht entkoppelt sind.

Sind die Meß- und Korrekturmöglichkeiten für Fokuslage und Schieflage in dieser Weise voneinander abhängig, ist es zeitaufwendig, die gewünschten Voraussetzungen sowohl für die Fokuslage als auch die Schieflage des Wafers zu erfüllen, da bei Korrektur der einen Größe stets auch die andere mit verändert wird und die Annäherung an den Idealzustand iterativ erfolgen muß. Wird also zunächst der Fokus eingestellt und danach die Schieflage korrigiert, wandert infolge der Korrektur der Schieflage der Fokus wieder aus. Nun sind zwar die Voraussetzungen bezüglich der Schieflage erfüllt, die Probenoberfläche ist aber nicht ausreichend fokussiert. Wird in der Folge die Fokuslage korrigiert, besteht wiederum die Gefahr einer Veränderung der Nivellierung bzw. Ausrichtung der Waferoberfläche zur Meßanordnung, und es muß wiederum die Nivellierung geprüft und gegebenenfalls korrigiert werden. Dieses wechselweise Justieren bis zum erwünschten Erfolg genügt den Forderungen an ein hohes Kontroll- bzw. Fertigungstempo nicht.

Hiervon ausgehend liegt der Erfindung die Aufgabe zugrunde, eine optische Meßanordnung der eingangs beschriebenen Art derart weiterzubilden, daß lokale Neigungen und Unebenheiten der Probenoberfläche festgestellt werden und eine Korrektur der Neigungsabweichung der Probenoberfläche bezüglich der optischen Achse der Meßanordnung erfolgt, die mit einer hohen Genauigkeit und in kurzer Zeit ausgeführt wird und die von einer Fokussierung der Probenoberfläche entkoppelt ist.

Die Aufgabe wird erfindungsgemäß durch die Anspruch 1, 4 gelöst. Vorteilhafte Ausgestaltungen und Weiterbildungen der Erfindung ergeben sich aus den Unteransprüchen.

Weiterhin liegt der Erfindung die Aufgabe zugrunde, eine Meßanordnung anzugeben, mit der lokale Neigungen und Unebenheiten einer Probenoberfläche mit hoher Genauigkeit und unabhängig von einer Fokussierung festgestellt werden.

Die Aufgabe wird erfindungsgemäß durch die Ansprüche 6 (Vorrichtung) und 10 (Verfahren) gelöst. Vorteilhafte Ausgestaltungen und Weiterbildungen der Erfindung ergeben sich aus den Unteransprüchen.

Erfindungsgemäß ist bei einer optischen Meßanordnung mit einem Ellipsometer und mit einer Einrichtung zur Ermittlung und Korrektur von Richtungsabweichungen zwischen der Normalen auf die Probenoberfläche und der Winkelhalbierenden zwischen Ein- und Ausfallstrahl des Ellipsometers vorgesehen, daß ein Richtungskontrollstrahl im wesentlichen in Richtung der Winkelhalbierenden auf die Probe gerichtet ist, wobei dessen Auftreffort im Auftreffort des Einfallstrahles des Ellipsometers liegt, optische Mittel zur Abbildung des Rückreflexes des Richtungskontrollstrahles auf einen Flächendetektor vorgesehen sind, der Flächendetektor mit einer Auswerteschaltung in Verbindung steht und an den Ausgängen der Auswerteschaltung Stellbefehle für ein mit dem Probentisch verbundenes Stellsystem verfügbar sind, wobei durch die Stellbefehle die Verkippung des Probentisches veranlaßt wird, bis die Position des Rückreflexes auf dem Flächendetektor der vorgegebenen Position entspricht, bei der die Richtung der Normalen mit der Richtung der Winkelhalbierenden übereinstimmt.

Ist vorteilhafterweise als Flächendetektor ein Vier-Quadrantendetektor vorgesehen, können die auf jeden Quadranten treffenden anteiligen Lichtmengen des Rückreflexes als Auswertekriterien für Abweichungen der Richtung der Normalen von der Richtung der Winkelhalbierenden dienen. In Abhängigkeit von den so ermittelten Abweichungen kann die Verkippung des Probentisches, auf dem die Probe aufliegt, veranlaßt werden.

Damit ist eine Anordnung geschaffen, die bei geringem technischen Aufwand mit hoher Effizienz die Ausrichtung der Probenoberfläche ermöglicht. Die Empfangsfläche des Vier-Quadrantensensors ist dabei vorteilhafterweise so justiert, daß die Richtung der Winkelhalbierenden genau dann der Richtung der Normalen entspricht, wenn auf alle vier Quadranten die gleichen Lichtmengen treffen.

In einer Ausgestaltung der Erfindung ist als Quelle für den Richtungskontrollstrahl ein fokussierbarer Diodenlaser vorgesehen, der linear polarisiertes Licht beispielsweise der Wellenlängen λ = 670 nm abstrahlt. Im Strahlengang zwischen dem Diodenlaser und der Probenoberfläche ist ein Polarisationsteiler vorhanden, dem aus Sicht des Diodenlasers eine λ/4-Platte nachgeordnet ist. Auf dem Weg zur Probe wird das linear polarisierte Licht bei Durchtritt durch die λ/4-Platte in zirkular polarisiertes Licht gewandelt. Im Rücklauf von der Probe wird bei erneutem Durchgang durch die λ/4-Platte aus dem zirkular polarisierten Licht wieder linear polarisiertes Licht, jedoch mit einer Polarisationsdrehung von π/2, was vorteilhaft zur Auskopplung des Rückreflexes an der Teilerfläche des Polarisationsteilers genutzt wird. Von der Teilerfläche wird der reflektierte Richtungskontrollstrahl auf die Empfangsflächen des Vier-Quadrantensensors gelenkt, wo die Auswertung seiner Position in der bereits beschriebenen Weise erfolgt. Damit ist es möglich, mit vorgefertigten optischen Baugruppen einen effizienten und kostengünstigen Aufbau der Meßanordnung zu erzielen.

Im Rahmen der Erfindung liegt es aber auch, das Licht des Diodenlasers ohne Zwischenschaltung eines Polarisationsteilers und einer λ/4-Platte über den Umlenkspiegel auf die Probenoberfläche und von dort zurück auf den Vier-Quadrantensensor zu richten, wodurch sich vorteilhaft die Anzahl der aufzuwendenden optischen Baugruppen reduzieren läßt und vor allem stark intensitätsschwächende Baugruppen im Strahlengang vermieden werden.

Eine solche Ausführung wird beispielsweise erzielt, wenn der Richtungskontrollstrahl nicht exakt in Richtung der Winkelhalbierenden auf die Probenoberfläche gerichtet ist, so daß der von der Probenoberfläche reflektierte Richtungskontrollstrahl nicht wieder in den ankommenden Strahlengang zurückfällt und der Vier-Quadrantensensor unmittelbar in den reflektierten Strahlengang gestellt werden kann. Wegen der getrennten Strahlführung ergibt sich auch noch der Vorteil, daß eine gegenseitige Beeinflussung des auf die Probenoberfläche ein- und ausfallenden Lichtes des Richtungskontrollstrahles nicht möglich ist.

Selbstverständlich ist die Erfindung nicht ausschließlich auf die Verwendung von Diodenlaser an sich und auch nicht auf die Wellenlänge von λ = 670 nm beschränkt; andere geeignete Strahlungsquellen und Wellenlängen sind denkbar.

In einer weiteren bevorzugten Ausgestaltung umfaßt das Stellsystem zur Verkippung des Probentisches zwei Piezo-Translatoren, von denen jeweils ein Ende gestellfest angelenkt und das zweite Ende gegen den Probentisch abgestützt ist, wobei der Probentisch in der Art einer Dreipunktlagerung auf diesen beiden Enden der Translatoren und auf einer gestellfesten Lagerstelle ruht und diese drei Auflagepositionen radialsymmetrisch auf einem Kreisumfang verteilt sind.

Insbesondere bei Einsatz der erfindungsgemäßen Meßanordnung im Zusammenhang mit der Kontrolle bzw. Messung von Schichtdicken an Waferoberflächen sollten Piezo-Translatoren mit einem Hub von 200 µm vorgesehen sein, während die gestellfeste Lagerstelle als Prismenauflage ausgebildet sein kann, wobei der Abstand zwischen den Auflagepositionen auf dem Kreisumfang vorteilhaft etwa 120 mm beträgt.

Die Erfindung bezieht sich weiterhin auf eine Meßanordnung mit einem Spiegelobjektiv, dessen Zentralspiegel einen Schattenbereich bildet (nicht genutzter Aperturraum des Spiegelobjektivs). In diesen Schattenbereich sind optische Mittel angeordnet, die einen Richtungskontrollstrahl einer Nivelliereinrichtung im wesentlichen entlang der optischen Achse des Spiegelobjektivs auf einen Meßort auf der Probe richten und die den vom Meßort reflektierten Richtungskontrollstrahl auf einen ortsauflösenden Detektor richten. Hiermit ist ein besonders kompakter und platzsparender Aufbau der Meßanordnung möglich. Insbesondere ist der Strahlengang der Nivelliereinrichtung getrennt von dem normalen Strahlengang des Spiegelobjektivs. Dadurch wird das ansonst an Einspiegelelementen auftretende und für die Meß- und Empfangsstrahlung störende Streulicht des Richtungskontrollstrahls vermieden. Auf diese Weise können mehrere Strahlengänge, die zwar eine gemeinsame optische Achse aufweisen, deren Strahlungen sich jedoch gegenseitig nicht durchdringen, auf die Probenoberfläche gerichtet sein, wie im folgenden noch gezeigt wird.

Für die Strahlführung der Nivelliereinrichtung kann einerseits ein Strahlenteiler vorgesehen sein, mit dem der vom Meßort reflektierte Richtungskontrollstrahl aus dem Strahlengang des beleuchtenden Richtungskontrollstrahls ausgekoppelt und auf den Detektor geführt wird. Dies ist im Falle des parallelen Verlaufs des Richtungskontrollstrahls zur optischen Achse des Spiegelobjektivs notwendig. Bei exakt senkrechter Ausrichtung des Meßortes zur optischen Achse wird der Richtungskontrollstrahl vom Meßobjekt in sich selbst reflektiert. Andererseits können auch die Strahlengänge von beleuchtendem und reflektiertem Richtungskontrollstrahl etwas voneinander verschieden sein und eine geringe Neigung gegenüber der optischen Achse aufweisen. In diesem Fall genügt ein Umlenkspiegel oder Umlenkprisma, um den reflektierten Richtungskontrollstrahl auf den Detektor zu richten. Die etwas unterschiedliche Neigung von beleuchtendem und reflektiertem Richtungskontrollstrahl bezüglich der optischen Achse der Meßanordnung wird bei der Auswertung der Detektorsignale berücksichtigt, um eine genaue Bestimmung der Neigung des Meßortes zu der optischen Achse der Meßanordnung zu ermöglichen.

Natürlich ist auch eine Anordnung mit zwei Umlenkelementen zwischen dem Objektiv und dem Meßort möglich, von denen das eine Umlenkelement den Richtungskontrollstrahl auf den Meßort und das andere den reflektierten Richtungskontrollstrahl auf den Detektor richtet.

Darüber hinaus kann mit einer Auswerteschaltung und einem Stellsystem die Neigung der Probe mit dem darauf befindlichen Meßort derart verändert werden, daß Abweichungen der Senkrechten auf dem Meßort von der optischen Achse der Meßanordnung auf einen vorbestimmten Wert oder auf Null eingestellt oder geregelt werden.

Die Nivelliereinrichtung wird parallel mit der normalen Funktion des Spiegelobjektivs verwendet. In dieser Funktion führt das Spiegelobjektiv optische Strahlung zum Meßort und es empfängt die vom Meßort kommende Strahlung. Das Spiegelobjektiv dient also zu Beleuchtungszwecken wie auch zur visuellen oder elektronischen Beobachtung des Meßortes und/oder der Durchführung der optischen Strahlung einer Fokussiereinrichtung und/oder zur Aufnahme der vom Meßort kommenden Strahlung für ein Spektralphotometer. Zudem kann auch noch ein Ellipsometer, insbesondere auch ein Spektralellipsometer mit einem eigenen Strahlengang auf den Meßort ausgerichtet sein.

Weiterhin bezieht sich die Erfindung auf ein Verfahren zur Messung der Neigung eines von einem Objektiv abgebildeten Meßortes auf einer Probe bei dem ein Richtungskontrollstrahl durch eine Strahlungsquelle erzeugt und zur oder in die Nähe der optischen Achse des Objektivs in einem Bereich zwischen dem Objektiv und dem Meßort gebracht wird. Dort wird er in die Richtung des Meßortes umgelenkt. Nach der Reflexion des Richtungskontrollstrahls am Meßort wird der reflektierte Richtungskontrollstrahl im Bereich zwischen dem Meßort und dem Objektiv aus der Umgebung der optischen Achse weggelenkt und auf einen ortsauflösenden Detektor gerichtet. Aus den Detektorsignalen wird die Neigungsabweichung der Senkrechten auf dem Meßort von der optischen Achse des Objektivs ermittelt.

Dabei kann der Richtungskontrollstrahl im Bereich zwischen dem Objektiv und dem Meßort parallel zur optischen Achse des Objektivs oder mit einer geringen Neigung zur optischen Achse des Objektivs verlaufen. Im Falle der parallelen Ausrichtung des Richtungskontrollstrahls zur optischen Achse ist die Auswertung der Detektorsignale für die Neigungsbestimmung des Meßortes unabhängig von einer Fokussierung des Meßortes mit einem Fokusmeßsystem. Die Neigung des Meßortes kann somit vorteilhafterweise separat vom Fokuszustand ermittelt und korrigiert werden.

Im Fall eines zur optischen Achse geringfügig geneigten Richtungskontrollstrahls wird diese Neigung (Bereich 0-2°) entweder bei der Justierung des Detektors oder bei der Auswertung der Detektorsignale berücksichtigt. Auch hier ist die Auswertung der Detektorsignale von der Fokussierung mit einer Fokussiereinrichtung im wesentlichen unabhängig. Es werden jedoch weniger optische Bauteile für die Neigungsmessung benötigt als im Fall des zur optischen Achse parallel laufenden Richtungskontrollstrahls.

Das beschriebene Verfahren zur Neigungsmessung kann für jedes den Meßort aufnehmende und abbildende Objektiv genutzt werden. Insbesondere ist das Verfahren bei einem Spiegelobjektiv einsetzbar, in dessen nicht genutztem Aperturraum, also im Schattenbereich des Zentralspiegels des Spiegelobjektivs, die Umlenkung des Richtungskontrollstrahls zum Meßort oder vom Meßort ohne Kollision mit anderen Strahlengängen des Spiegelobjektivs erfolgen kann.

Zudem kann die Neigung der Probe mit Hilfe einer Auswerteschaltung und eines Stellsystems derart verstellt werden, daß ein vorgegebener Winkel zwischen der Senkrechten auf dem Meßort der Probe und der optischen Achse des Objektivs entsteht. Dieser Winkel kann auch zu Null eingestellt oder mit Hilfe einer Regelung geregelt werden, so daß die optische Achse des Objektivs senkrecht auf dem Meßort steht.

Eine besonders bevorzugte Ausgestaltungsvariante einer erfindungsgemäßen Meßanordnung wird in den Fällen erzielt, in denen neben dem Ellipsometer auch noch ein Spektralphotometer vorgesehen ist, das zusätzlich zur Messung mit dem Ellipsometer ebenfalls zur Schichtdickenmessung genutzt werden kann. Hierbei ist ein Probenmeßstrahl durch ein Spiegelobjektiv hindurch auf die Probenoberfläche fokussiert, und das von der Probe in das Spiegelobjektiv zurückreflektierte Licht des Probenmeßstrahles wird einem Spektrographen zur Auswertung zugeführt. Der Probenmeßstrahl bildet dabei einen vom Spiegelobjektiv ausgehenden Strahlenhohlkegel, der mit seiner Kegelspitze auf dem Meßort steht und bei dem der Hohlraum im Kegelinneren nicht vom Probenmeßstrahl genutzt wird. Mit anderen Worten: Das Spiegelobjektiv weist in Richtung zur Probe einen von dem Probenmeßstrahl nicht benutzten freien Aperturraum auf, dessen räumliche Ausdehnung dem Inneren des Hohlkegels entspricht.

Um die optischen Mittel und Verfahrensschritte zur Nivellierung der Probe bzw. zur Korrektur von Winkelablagen der Probenoberfläche und die optischen Mittel und Verfahrensschritte zur spektralphotometrischen Erfassung der Probeneigenschaften voneinander zu entkoppeln und damit zu verhindern, daß eine gegenseitige Beeinflussung erfolgt, ist erfindungsgemäß vorgesehen, den Richtungskontrollstrahl innerhalb des Hohlkegels bzw. in dem vom Spiegelobjektiv nicht benutzten freien Aperturraumes zu führen.

Zu diesem Zweck ist zwischen Spiegelobjektiv und Probenoberfläche, innerhalb dieses unbenutzten Aperturraumes, ein Umlenkspiegel mit einer um vorzugsweise 45° gegen die optische Achse des Spiegelobjektivs geneigten Spiegelfläche angeordnet. Der vom Diodenlaser kommende und auf die Probenoberfläche fokussierte Richtungskontrollstrahl ist zunächst seitlich durch den Strahlenhohlkegel hindurch auf die Spiegelfläche des Umlenkspiegels gerichtet und wird von dieser zur Probenoberfläche hin umgelenkt. Mit dieser Führung des Richtungskontrollstrahl innerhalb des Strahlenhohlkegels des Probenmeßstrahies wird erreicht, daß Richtungskontrollstrahl und Probenmeßstrahl zeitgleich auf denselben Meßpunkt fokussiert sein können, wobei sie sich nicht oder zumindest nicht wesentlich beeinflussen.

Von der Probenoberfläche wird der Richtungskontrollstrahl in den unbenutzten Aperturraum des Spiegelobjektivs zurückgeworfen, verläuft innerhalb des unbenutzten Aperturraum bis zum Umlenkspiegel und wird von diesem wie bereits beschrieben direkt oder indirekt auf den Vier-Quadrantensensor gerichtet. Die äußere Kontur des Umlenkspiegels sollte dabei vorteilhafterweise der Innenform des Strahlenhohlkegels angeglichen sein, so daß der vom Spiegelobjektiv nicht benutzte Aperturraum optimal für den Richtungskontrollstrahl ausgenutzt werden kann.

Der besondere Vorteil besteht wie bereits angedeutet darin, daß die Entkopplung der Strahlengänge gewährleistet ist und trotzdem auch ein kompakter Aufbau erzielt werden kann, bei dem die Vielzahl der erforderlichen optischen Baugruppen in der Nähe des Meßortes untergebracht sind.

Selbstverständlich gehört zu derartigen hochgenauen Meßanordnungen auch eine Kontroll- und Korrekturmöglichkeit der Fokuslage der Probenoberfläche, bezogen auf die Meßstrahlengänge von Ellipsometer und Spektralphotometer. Deshalb ist zusätzlich zu den bisher angegebenen optischen Baugruppen auch noch ein Fokusmeß- und Nachstellsystem vorhanden. Dabei ist ausgehend von einer bekannte Ausführungsform ein Fokusmeßstrahl über eine zur Hälfte abgeschottete Pupille schräg auf die Probenoberfläche gerichtet, und in dem von der Probenoberfläche reflektierten Licht ist ein positionsempfindlicher Detektor angeordnet. Wird die Probe in Richtung der optischen Achse verschoben, ist am Ausgang des Detektors ein sich proportional zur Verschiebeweite änderndes Meßsignal verfügbar, anhand dessen die Fokuslage ermittelt und korrigiert werden kann.

Der Fokusmeßstrahl ist ebenso wie der zur Spektralphotometrie dienende Probenmeßstrahl durch das Spiegelobjektiv hindurch auf den Meßort gerichtet, während der Richtungskontrollstrahl in den Bereich zwischen Spiegelobjektiv und Probenoberfläche seitlich eingestrahlt und von dem dort positionierten Umlenkspiegel auf den Meßort gerichtet ist.

Insofern ergibt sich aus den erfindungsgemäßen Merkmalen eine optische Meßanordnung, die einerseits über alle zur Lösung der Meßaufgabe erforderlichen Baugruppen und Bauelemente verfügt und trotzdem so aufgebaut werden kann, daß die Vielzahl der Meßaufgaben und Meßschritte, auf einen sehr kleinen Abschnitt der Probenoberfläche konzentriert, ungehindert ausgeführt werden können.

Die durch das Spiegelobjektiv hindurchgehende und auf den Messort gerichtete oder von dort kommende optische Strahlung kann also sowohl von einer Beleuchtungsvorrichtung kommen als auch zu einer visuellen Beobachtungseinrichtung und/oder zu einer elektronischen Bildaufnahmeeinrichtung hinführen als auch zugleich einem Fokusmeßsystem und/oder einem Spektrographen dienen. Gleichzeitig kann auch noch ein Ellipsometer zur ellipsometrischen Messung auf dem Messort vorgesehen sein.

Die Erfindung soll nachfolgend anhand eines Ausführungsbeispieles näher erläutert werden. In den zugehörigen Zeichnungen zeigen
- Fig.1: den Gesamtaufbau einer optischen Meßanordnung mit Ellipsometer, Spektralphotometer, Nivelliereinrichtung und Fokusmeßeinrichtung
- Fig.2: eine erste Variante der erfindungsgemäßen Führung des Richtungskontrollstrahles
- Fig.3: die Anordnung eines Umlenkspiegels für den Richtungskontrollstrahl am Spiegelobjektiv
- Fig.4: eine zweite Variante der erfindungsgemäßen Führung des Richtungskontrollstrahles
- Fig.5: eine Ansicht in Richtung auf die Empfangsflächen des Vier-Quadrantenempfängers
- Fig.6: die Auflagepositionen des Probentisches auf das Stellsystem
- Fig.7: eine schematische Darstellung der zur Nivelliereinrichtung gehörenden Auswerteschaltung

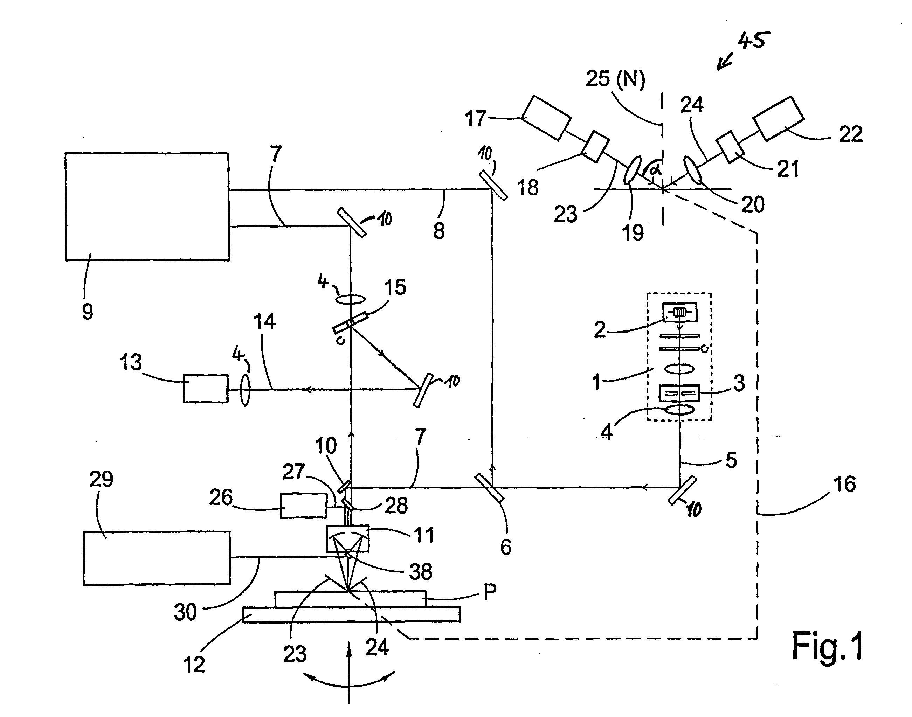

Die Erfindung wird im Folgenden beispielhaft anhand eines optischen Schichtdickenmeßsystems erläutert, das zu einer Fertigungslinie für Wafer gehört und mit dem die erzielte Waferstruktur unmittelbar kontrolliert werden kann. Eine derartige Meßanordnung ist in Fig.1 schematisch dargestellt.

Die Meßanordnung umfaßt zunächst die optischen Baugruppen eines Spektralphotometers mit einer Beleuchtungsvorrichtung 1, in der eine Halogenlampe 2 vorgesehen ist, deren Wendel in die Öffnung einer Deuteriumlampe 3, die ebenfalls Teil der Beleuchtungsvorrichtung 1 ist, abgebildet wird. Das von diesen beiden Lampen 2,3 erzeugte Licht, das gegebenenfalls gefiltert wird, wird mit geeigneten Linsen 4 zu einem Beleuchtungsstrahlengang 5 gebündelt.

Der Beleuchtungsstrahlengang 5 erreicht über Spiegel, Linsen und Blenden, deren Anordnung in solchen Fällen dem Fachmann geläufig ist und deshalb hier nicht näher erläutert werden muß, einen Strahlteiler 6, beispielsweise einen teildurchlässigen Spiegel, an dessen Teilerfläche der Beleuchtungsstrahlengang 5 in einen Probenmeßstrahl 7 und einen Referenzstrahlengang 8, gegebenenfalls mit unterschiedlicher Intensität beider Strahlengänge, verzweigt wird.

Der Referenzstrahlengang 8 wird wiederum mit Hilfe geeignet angeordneter optischer Baugruppen wie Spiegel und Linsen, zu einem Spektrographen 9 geleitet.

Der Probenmeßstrahl 7 dagegen ist nach Richtungsänderung mittels Umlenkspiegel 10 durch ein Spiegelobjektiv 11 hindurch auf eine Probe P, in diesem Fall einen Wafer, gerichtet, der auf einen Probentisch 12 aufgelegt ist.

Mit dem Probenmeßstrahl 7 wird ein Zielgebiet auf der Probe P beleuchtet und das von der Probenoberfläche in das Spiegelobjektiv 11 zurück reflektierte Licht nun ebenfalls dem Spektrographen 9 zugeführt. Hier werden in bekannter Weise Meßlicht und Referenzlicht zwecks Auswertung spektral zerlegt und zeitgleich auf eine in den Spektrographen integrierte und zeichnerisch nicht gesondert dargestellte CCD-Matrix abgebildet.

Es kann vorausgesetzt werden, daß die Methode der Spektralphotometrie hinreichend bekannt ist und sich eine weitergehende Erläuterung an dieser Stelle ebenfalls erübrigt.

Zweckmäßigerweise ist eine CCD-Kamera 13 vorgesehen, die dazu dient, das zu untersuchende Gebiet der Probenoberfläche auf einem Monitor darzustellen, um so die visuelle Auswahl eines bevorzugt zu kontrollierenden Abschnittes zu ermöglichen. Zur Ein- und Auskopplung des zur visuellen Beobachtung dienenden Strahlenganges 14 in den von der Probe P kommenden Probenmeßstrahl 7 ist ein Pinhole-Spiegel 15 vorgesehen.

Um auch komplexe Schichtsysteme auf Wafern hochgenau und zuverlässig vermessen zu können, kommt in der zur Erläuterung ausgewählten Meßanordnung nicht nur das bisher beschriebene Spektralphotometer zum Einsatz, sondern auch noch ein Ellipsometer 45, so daß die Ermittlung des Meßergebnisses mit zwei Meßverfahren möglich ist.

Aus Gründen der Übersichtlichkeit sind die Baugruppen des Ellipsometers 45 in Fig.1 separat dargestellt, und zwar oben rechts. Die Beziehung der Ellipsometerbaugruppen zum Meßort M auf der Probe P ist durch eine gestrichelte Linie 16 angedeutet.

Mit dem Ellipsometer 45 wird dieselbe Struktur bzw. derselbe Meßort M vermessen, wie jeweils auch mit dem Spektralphotometer. Zu diesem Zweck ist das Licht einer Xenonlampe 17 über einen Polarisator 18 und eine Linse 19 auf den Meßort M gerichtet. Das vom Meßort M reflektierte Licht erreicht durch ein Objektiv 20 sowie über einen Analysator 21 die Auswerteeinheit 22.

Da linear polarisiertes Licht einer vorgegebenen Polarisationsrichtung und Wellenlänge unter einem großen Winkel α auf die Oberfläche der Probe P gerichtet ist, werden bei Reflexion an der Probenoberfläche die Wellenamplitude und die Phase der Polarisationskomponenten parallel und senkrecht zur Einfallsebene unterschiedlich geändert. Insofern ergibt die Untersuchung des Polarisationszustandes die Möglichkeit, Rückschlüsse auf die Oberflächenstruktur bzw. auf Schichtdicken am Meßort M zu ziehen.

Die Baugruppen des Ellipsometers 45 sind so angeordnet, daß Einfallstrahl 23 und Ausfallstrahl 24 seitlich am Spiegelobjektiv 11 vorüber geführt sind. Zur Verdeutlichung dessen sind in Fig.1 Einfallstrahl 23 und Ausfallstrahl 24 des Ellipsometers 45 andeutungsweise nochmals über der auf dem Probentisch 12 aufliegenden Probe P dargestellt.

Eine wichtige Voraussetzung für genaue Messungen von Schichtdicken an kleinen Strukturen ist, daß sich erstens keine Strukturkanten im Meßfenster befinden, da sonst das Ergebnis der Schichtdickenmessung verfälscht werden würde, und zweitens, daß die Oberfläche der Probe P zumindest an der Meßposition senkrecht zu dem auf die Oberfläche einfallenden Probenmeßstrahl 7 und auch senkrecht zur Winkelhalbierenden 25 des Winkels liegt, den Einfallstrahl 23 und Ausfallstrahl 24 miteinander einschließen. Mit anderen Worten: Die Normale N auf die Probe P am Meßort M, die Einfallsrichtung des Probenmeßstrahls 7 auf die Probe P und die Winkelhalbierende 25 müssen sich mit höchstmöglicher Genauigkeit überdecken. In Fig.1 ist der Idealzustand symbolisiert, indem die Normale N auf die Probenoberfläche überdeckt mit der Winkelhalbierenden 25 dargestellt ist. Zur Verdeutlichung dessen ist das Bezugszeichen für die Normale N in Fig.1 neben der Winkelhalbierenden 25 in Klammern gesetzt.

Diese Forderung setzt voraus, daß vor jeder Schichtdickenmessung eine gegebenenfalls vorhandene Verkippung der Normalen N gegenüber dem Probenmeßstrahl 7 und der Winkelhalbierenden 25 ermittelt und korrigiert werden muß. Solche Verkippungen bzw. Schieflagen können sich ergeben, wenn der Wafer an seiner Oberfläche selbst uneben ist und/oder uneben auf den Probentisch 12 abgelegt bzw. angesaugt ist.

Als weitere Voraussetzung für eine hohe Meßgenauigkeit ist die präzise Fokuslage des Meßortes M zu gewährleisten. Zui diesem Zweck ist die Meßanordnung mit einem Fokusmeßsystem 26 ausgestattet, bei dem es sich beispielsweise um einen Laserautofokus nach einem aus dem Stand der Technik bekannten Prinzip handelt. Dabei wird, wie in Fig.1 angedeutet, das Licht einer Laserdiode in Form eines Fokusmeßstrahles 27 mit einem Spiegel 28 auf die Probe P gelenkt. Im Strahlengang des Fokusmeßstrahles 27 ist die Hälfte der Pupille abgeschattet, so daß dessen Licht schräg auf die Probenoberfläche fällt. Nur wenn die Probenoberfläche in der Fokusebene liegt, entsteht ein zur optischen Achse symmetrischer Leuchtfleck. Ist die Probenoberfläche in Richtung der optischen Achse verschoben, d.h. liegt die Probenoberfläche außerhalb der Fokusebene, ist der Leuchtfleck seitlich zur optischen Achse verschoben. Es wird also ein zur Abweichung aus der Fokusebene proportionales Meßsignal erzeugt, das über ein angeschlossenes Stellsystem zur Nachstellung der Fokuslage genutzt werden kann. Somit kann ein Fokusmeßsystem 26 vorgesehen werden, bei dem ein von einer Laserdiode ausgehender Fokusmeßstrahl 27 über eine zur Hälfte augeschottete Pupille schräg auf die Probenoberfläche gerichtet ist und in dem von der Probenoberfläche reflektierten Licht ein positionsempfindlicher Detektor angeordnet ist, wobei bei einer Verschiebung der Probe P in Richtung der optischen Achse am Ausgang des Detektors ein sich proportional zur Verschiebeweite änderndes Meßsignal verfügbar ist, das zur Korrektur der Fokuslage der Probenoberfläche genutzt wird.

Die beschriebene Meßanordnung muß also folgende Forderungen erfüllen können, damit eine hochgenaue Messung der Schichtdicke möglich ist:
- zunächst muß ein zu vermessender Oberflächenabschnitt mit möglichst homogener Struktur ausgewählt werden;
- danach ist eine Bewegung des Probentisches 12 so zu veranlassen, daß die zu vermessende Struktur in den Zielbereich gerät, wobei für das Suchen und Einfangen des Meßortes M die CCD-Kamera 13 genutzt werden kann;
- im nächsten Schritt ist eine gegebenenfalls vorhandene Abweichung der Normalen N auf die Probenoberfläche am Meßort M von der Richtung des einfallenden Probenmeßstrahles 7 des Spektralphotometers und von der Winkelhalbierenden 25 zwischen Einfallstrahl 23 und Ausfallstrahl 24 des Ellipsometers 45 zu ermitteln;
- bei der Feststellung einer Abweichung ist die Probe P zu nivellieren, d.h. der Probentisch 12 mit der aufliegenden Probe P ist so zu verkippen, daß Winkelfehler ausgeglichen werden;
- bevor die Messung vorgenommen werden kann, ist weiterhin die Fokuslage der Probenoberfläche am Meßort M zu kontrollieren und gegebenenfalls zu korrigieren, wozu das vorhandene Fokusmeßsystem 26 einschließlich einer nachgeordneten Stelleinrichtung zur Verschiebung des Probentisches 12 in Richtung der optischen Achse genutzt wird;
- nach diesen Lagekorrekturen können nun die eigentlichen Messungen vorgenommen werden, d.h. Messung der Schichtdicke entweder mit dem Spektralphotometer oder dem Ellipsometer 45 oder auch mit beiden sowie weitere Prüfungen der Strukturen auf der Probe P.

In der weiteren Beschreibung soll die Verfahrensweise zur Korrektur von Lageabweichungen der Normalen N von der Winkelhalbierenden 25 vereinfachend mit dem Begriff Nivellierung bezeichnet werden. Bei den aus dem Stand der Technik bekannten Anordnungen und Verfahren zur Nivellierung und zur Korrektur der Fokuslage besteht allgemein das Problem, daß die erforderlichen Schritte zur Nivellierung und Fokussierung nicht unabhängig voneinander vorgenommen werden können.

So muß beispielsweise erst die Fokuslage ermittelt und korrigiert werden, damit die Ausrichtung der Normalen N gemessen werden kann. Zum Ausgleich von Richtungsabweichungen der Normalen N von der Winkelhalbierenden 25 muß die Probe P verkippt werden, was zu einer unerwünschten Defokussierung führt. Es muß also die Fokuslage erneut gemessen und nachfokussiert werden. Im Anschluß an die Nachfokussierung ist zu kontrollieren, ob die Nivellierung noch stimmt, gegebenenfalls sind Abweichungen zu korrigieren.

Insofern ist leicht einzusehen, daß die Abhängigkeit von Nivellierung und Fokussierung nachteiligerweise zeitaufwendig ist und demzufolge auch dem Bestreben nach hohem Fertigungstempo bei einer Massen- bzw. Fließfertigung entgegenwirkt.

Zur Korrektur der Nivellierung bzw. zum Ausgleich der Winkelabweichungen zwischen der Normalen N auf die Probenoberfläche am Meßort M und der Winkelhalbierenden 25 ist erfindungsgemäß eine Nivelliereinrichtung 29 vorgesehen, deren Richtungskontrollstrahl 30 am Meßort M auf die Probenoberfläche gerichtet ist.

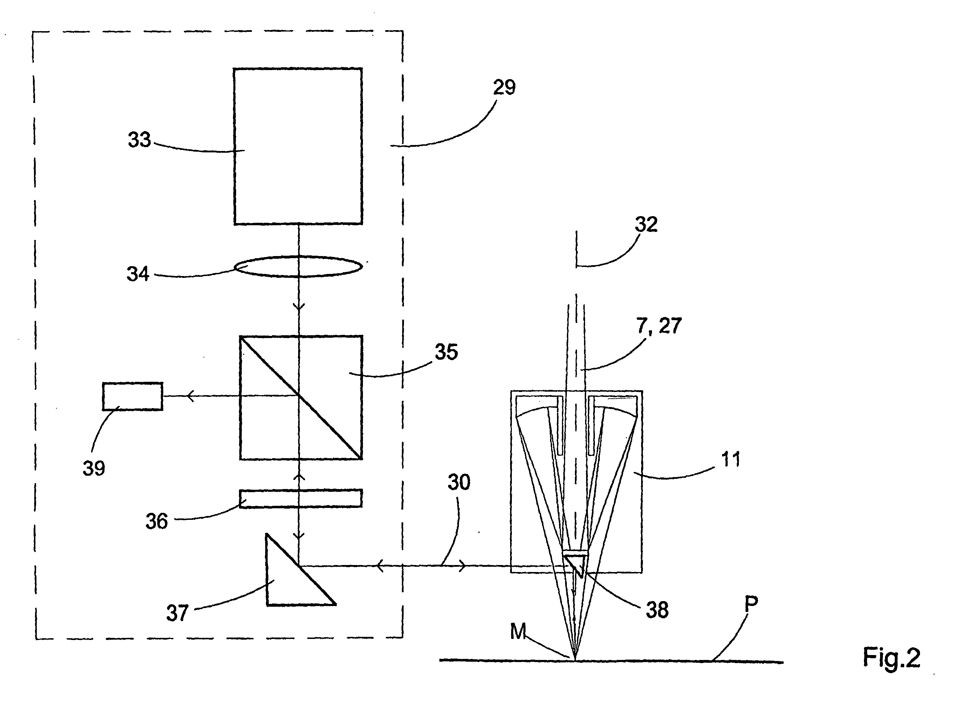

In Fig.2 ist eine erste Variante der Nivelliereinrichtung 29 dargestellt. Hier sind das Spiegelobjektiv 11 mit seiner optischen Achse 32 zu erkennen und auch die Strahlengänge von Probenmeßstrahl 7 und Fokusmeßstrahl 27 angedeutet, die durch das Spiegelobjektiv 11 hindurch auf den Meßort M gerichtet sind.

Nach Fig.2 besteht die Nivelliereinrichtung 29 im wesentlichen aus einem Diodenlaser 33, dessen linear polarisiertes Licht, vorzugsweise der Wellenlänge λ = 670 nm, mit Hilfe einer Optik 34 auf den Meßort M fokussiert wird. Als weitere optische Baugruppen sind ein Polarisationsteiler 35, eine λ/4-Platte 36, ein Umlenkspiegel 37 und ein Umlenkspiegel 38 vorgesehen. Das linear polarisierte Laserlicht des Diodenlasers 33 wird beim Durchgang durch die λ/4-Platte 36 in zirkular polarisiertes Licht gewandelt und erreicht über die Umlenkspiegel 37 und 38 den Meßort M.

Das vom Meßort M reflektierte zirkular polarisierte Licht des Richtungskontrollstrahles 30 tritt auf dem Rückweg, in umgekehrter Folge wieder umgelenkt durch die Umlenkspiegel 38 und 37, erneut durch die λ/4-Platte und wird dabei wieder zu linear polarisiertem Licht, jedoch mit einer Polarisationsdrehung von π/2. Aufgrund der veränderten Polarisationsrichtung kann der Rückreflex des Richtungskontrollstrahles 30 an der Teilerfläche des Polarisationsteilers 35 ausgekoppelt werden, wobei der ausgekoppelte Teil auf einen Vier-Quadrantensensor 39 gelenkt wird

Um die optischen Mittel und Verfahrensschritte zur Nivellierung von denen zur Messung und Korrektur der Fokuslage weitestgehend zu entkoppeln, ist der Umlenkspiegel 38 erfindungsgemäß in dem nicht benutzten freien Aperturraum des Spiegelobjektivs 11 angeordnet.

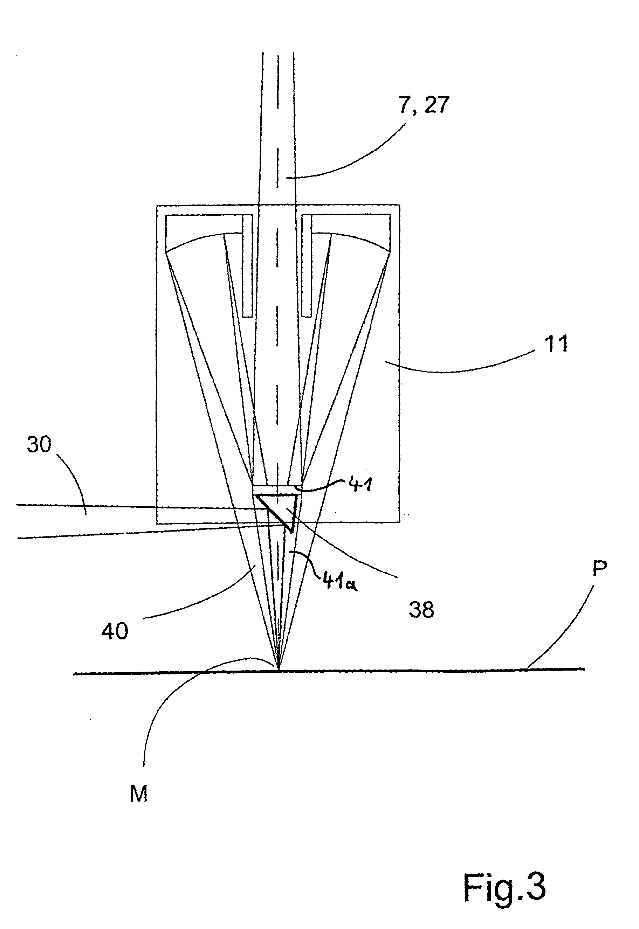

Das ist in Fig.3, die das Spiegelobjektivs 11 in einer noch weiteren Vergrößerung als in Fig.2 zeigt, verdeutlicht. Der vom Diodenlaser 33 kommende fokussierte Richtungskontrollstrahl 30 ist zunächst seitlich durch den Strahlenhohlkegel 40 des Spiegelobjektivs 11 hindurch auf den Umlenkspiegel 38 gerichtet und wird von diesem zur Probe P hin umgelenkt. Damit sind der Richtungskontrollstrahl 30 und der Strahlenhohlkegel 40, in welchem Probenmeßstrahl 7 und Fokusmeßstrahl 27 verlaufen, räumlich getrennt auf die Probe P gerichtet. Der Richtungskontrollstrahl 30 einerseits und Probenmeßstrahl 7 bzw. Fokusmeßstrahl 27 andererseits sind also zeitgleich ohne sich gegenseitig wesentlich zu beeinflussen auf denselben Meßort M fokussiert.

Der Umlenkspiegel 38 kann vorteilhaft an der Halterung des Zentralspiegels 41 des Spiegelobjektivs 11 befestigt sein (zeichnerisch nicht dargestellt) und sollte, wie in Fig.2 und auch in Fig.3 angedeutet, als Kegelstumpf ausgeführt sein, so daß seine Außenkontur der Innenkontur des Strahlenhohlkegels 40 angepaßt ist. Dadurch bleibt einerseits eine störungsfreie Apertur des Spiegelobjektivs 11 gewährleistet, andererseits kann aber der vom Spiegelobjektiv 11 nicht genutzte Aperturraum, also der Schattenbereich 41a des Zentralspiegels 41, optimal zur Führung des Richtungskontrollstrahles 30 genutzt werden.

Aufgrund dessen, daß der Richtungskontrollstrahl 30 fokussiert auf den Meßort M gerichtet ist, verringert sich die Wahrscheinlichkeit, das sich Strukturkanten im Meßbereich befinden, die das Meßergebnis verfälschen könnten. Der Einsatz eines Diodenlasers 33 mit Wellenlänge λ = 670 nm ermöglicht es zusätzlich, den Meßspot klein zu halten, was weiterhin die Wahrscheinlichkeit des Vorhandenseins von Strukturkanten im Meßbereich verringert. Bei der Justierung der Baugruppen ist sicherzustellen, daß der über den Richtungskontrollstrahl 30 auf den Meßort M gerichtete Spot hinsichtlich Größe, Justier- und Stabilitätstoleranz sicher im Auftreffort des Einfallstrahls 23 des Ellipsometers 45 liegt.

Die Größe der Empfangsfläche und die Position des Vier-Quadrantendetektors 39 sind auf die Größe des reflektierten Richtungskontrollstrahles 30 abgestimmt, die ihrerseits von der Länge des optischen Weges zwischen dem Meßport und der Empfangsfläche abhängig ist. Vorteilhaft sollte die Empfangsfläche 5 mm² bei allen vier Quadranten betragen.

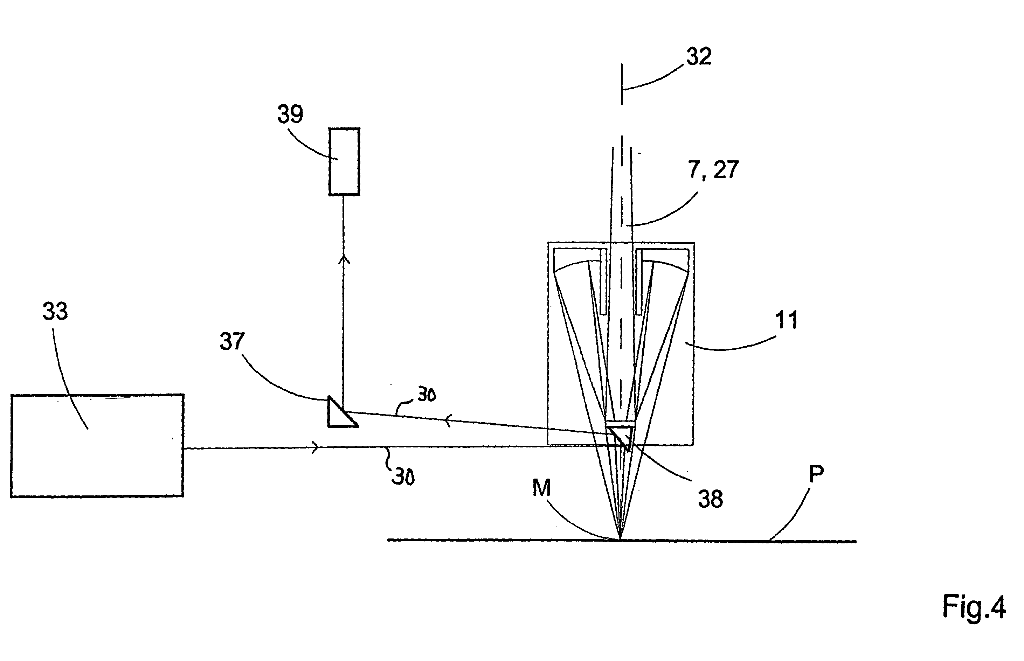

Die Verfahrensweise zur Nivellierung der Probe wird später erläutert. Zunächst sei auf eine zweite Variante der Nivelliereinrichtung 29 verwiesen, die in Fig.4 dargestellt ist. Hier ist wiederum beispielsweise der Diodenlaser 33 der Wellenlänge λ = 670 nm vorgesehen, dessen Licht ebenfalls durch Optik 34 (die in Fig.4 nicht dargestellt ist) fokussiert als Richtungskontrollstrahl 30 auf die Oberfläche der Probe P gelenkt wird. Allerdings ist abweichend von der Variante nach Fig.2 kein Polarisationsteiler und keine λ/4-Platte im Strahlengang vorgesehen. Zu bemerken ist jedoch, daß die Ausrichtung des auf den Meßort M gerichteten Richtungskontrollstrahles 30 nicht exakt der Richtung der Winkelhalbierenden 25 entspricht, sondern der Richtungskontrollstrahl 30 um einen geringen Winkelbetrag gegen die Winkelhalbierende 25 geneigt ist.

Dabei bewirkt diese Neigung, daß der Richtungskontrollstrahl 30 von der Probenoberfläche nicht wieder in dieselbe Richtung zurückgeworfen wird, aus der er auf die Probenoberfläche gerichtet ist, was dazu führt, daß er nicht in den Diodenlaser 33 zurück, sondern auf ein entsprechend positioniertes Umlenkprisma 37 fällt und von diesem auf den Vier-Quadrantensensor 39 gelenkt wird. Damit wird vorteilhaft erreicht, daß die Anzahl der optischen Baugruppen weiter reduziert ist (Polarisationsteiler und λ/4-Platte fehlen) und außerdem ein- und ausfallender Strahlengang des Richtungskontrollstrahles 30 voneinander entkoppelt sind.

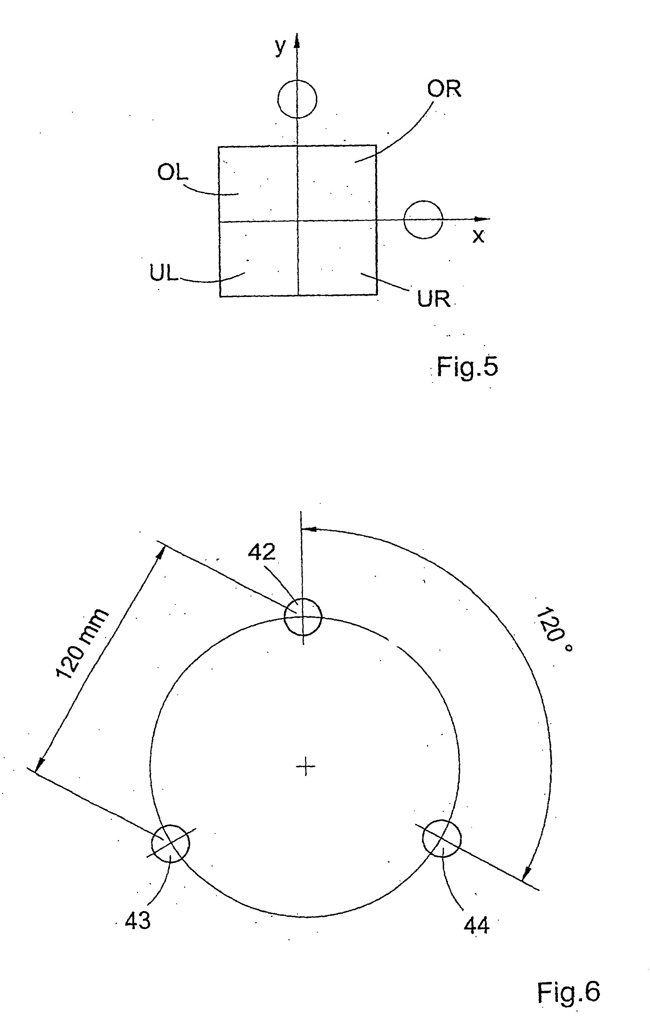

In Fig.5 sind die vier Quadranten des Vier-Quadrantensensors 39 beispielhaft dargestellt. Dazu sind die X-Achse und die Y-Achse eingezeichnet, auf die die Messungen bezogen sind.

Die Quadranten sind mit OL, UL, OR und UR definiert. Der Vier-Quadratensensor 39 wird als Null-Detektor eingesetzt, d.h. wenn auf die vier Quadraten OL, UL, OR und UR jeweils die gleiche Lichtmenge des reflektierten Richtungskontrollstrahles 30 mit kreisrundem Querschnitt fällt, ergeben sich für die am Ausgang des Detektors verfügbaren elektrischen Spannungen folgende mathematische Beziehungen:
für die X-Achse 0 = (U_{OR} + U_{OL}) - (U_{UR} + U_{UL})
für die Y-Achse 0 = (U_{OL} +U_{UL}) - (U_{OR} + U_{UR})
für die Reflektivität p Uₚ = (U_{OL}+U_{UL}+U_{OR}+U_{UR})

Auf diese Weise wird mit Hilfe des Vier-Quadrantensensors 39 ein Winkeldifferenzsignal X, ein Winkeldifferenzsignal Y und ein Summensignal (bezogen auf die Reflektivität) generiert. Das Summensignal kann dazu genutzt werden, die Leistung des Diodenlasers 33 dem Reflektionsgrad der Waferoberfläche über eine zwischengeschaltete Regelstufe anzupassen. Dies kann beispielsweise durch Pulsmodulation in der Weise erfolgen, daß die Pulsbreite und damit die Leistung des Diodenlasers bei kleiner werdendem Reflexionsgrad vergrößert bzw. umgekehrt bei größer werdendem Reflexionsgrad verringert wird.

Die Winkeldifferenzsignale werden über eine Auswerteschaltung 46, die als digitaler Regler ausgebildet sein kann, in Stellbefehle für ein Stellsystem 47, 47a gewandelt, das mit dem Probentisch 12 verbunden ist.

Aufbau und Funktionsweise des Stellsystems 47, 47a sollen zunächst anhand Fig.6 erläutert werden. In Fig.6 sind drei Auflagepositionen 42, 43 und 44 für den Probentisch 12 in einer Draufsicht dargestellt. Die drei Auflagepositionen 42, 43 und 44 sind auf einem Kreisumfang radialsymmetrisch angeordnet, d.h. sie sind auf dem Kreisumfang gleich weit voneinander entfernt. Die in der Geraden gemessene Entfernung zwischer jeweils zwei der Auflagepositionen 42, 43 und 44 kann vorteilhaft mit 120mm ausgeführt sein. Dabei wird die Auflage an der Position 42 durch ein gestellfestes Auflager realisiert. Der Probentisch 12 liegt dabei jeweils punktförmig auf und ist um die Auflageposition 42 verkippbar.

Die beiden übrigen Auflagepositionen 43 und 44 werden jeweils durch einen Piezo-Translator gebildet. Die Piezo-Translatoren, die zeichnerisch nicht dargestellt sind, sollten vorzugsweise eine Hublänge von ca. 200µm haben, wobei je nach Richtung der Längenänderung der Probentisch 12 an der Auflageposition 43 oder der Auflageposition 44 oder an beiden Auflagepositionen 43 und 44 angehoben oder abgesenkt wird und dabei, da die Höhe der Auflageposition 42 konstant bleibt, gegenüber der Zeichenebene verkippt wird.

Mit der Verkippung des Probentisches 12 verkippt auch die Normale N, und mit gezielt angesteuerten Piezo-Translatoren ist so eine definierte Neigungsänderung der Normalen N erzielbar.

Dieser Verkippung dienen die bereits vorgenannten Stellbefehle, die von der Abbildung des reflektieren Richtungskontrollstrahles 30 auf den Vier-Quadrantendetektor 39 in der bereits beschriebenen Weise abhängig sind.

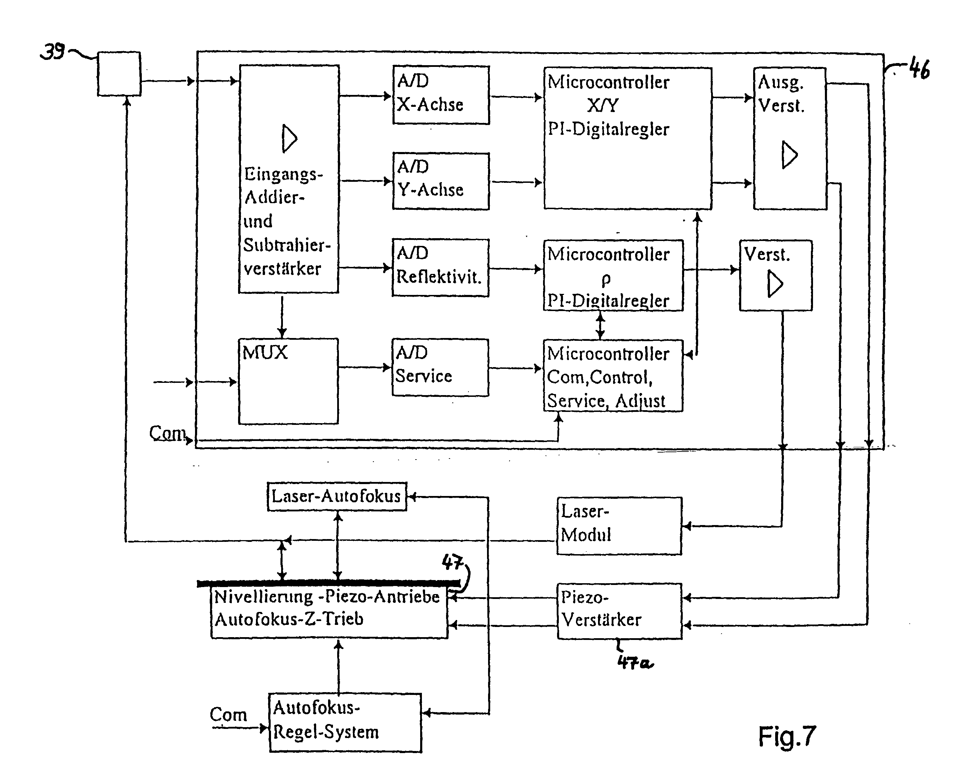

Ein Beispiel für die Ausführung der Auswerteschaltung 46 zur Gewinnung von Stellbefehlen ist in Fig.7 dargestellt. Hier ist ein Eingangs-Addier-und-Subtrahier-Verstärker zur Realisierung der weiter oben genannten mathematischen Beziehungen zwischen den Quadranten OL, UL, OR und UR vorgesehen, an dessen Eingang der Ausgang des Vier-Quadrantensensors 39 anliegt. Jeweils ein Mikro-Controller sorgt für Kommunikation, Steuerung, Justage und Service, für Pulsbreiten-Regelung in bezug auf die Reflektivität sowie für Pulsbreiten-Regelung in bezug auf die Schwenkung um die X-Achse und die Y-Achse. Zwischen Eingangsverstärker und Mikro-Controller sind jeweils A/D-Wandler zur Signalanpassung geschaltet. Die Ausgänge der Mikro-Controller sind über Verstärker mit dem Diodenlaser 33 (zwecks Nachregulierung der Laserrichtung) und mit den Piezo-Translatoren (zwecks Anhebung oder Absenkung der Auflagepositionen 43 und 44) verknüpft.

Auf diese Weise wird erfindungsgemäß ein kompakter Aufbau der gesamten Einrichtung erzielt und außerdem dafür gesorgt, daß beim Betreiben der Einrichtung die Nivellierung und Fokussierung voneinander entkoppelt sind. Insofern kann mit dieser Einrichtung vorteilhaft folgender Meßablauf ausgeführt werden:
- Auswahl des zu vermessenden Ortes auf der Oberfläche der Probe P;
- Suchen und Einfangen des ausgewählten Meßortes M mit Hilfe der CCD-Kamera 13;
- Messung der Ausrichtung der Normalen N mit Hilfe der Nivelliereinrichtung;
- Ausregelung der Abweichung der Normalen N mit Hilfe der Nivelliereinrichtung;
- Messung der Fokuslage der Probeoberfläche im Zielbereich;
- Ausregelung von Abweichungen der Fokuslage über ein gesondertes Autofokus-Regelsystem, das ebenfalls mit dem Probentisch gekoppelt ist und schließlich
- Messung der Schichtdicke entweder mit dem Spektralphotometer oder dem Ellipsometer 45 oder mit beiden Meßsystemen.

## Patentansprüche

1. Optische Messanordnung mit einem Ellipsometer (45), bei dem ein Einfallstrahl (23) mit polarisiertem Lichtes unter einem Winkel α≠90° auf einen Messort (M) an der Oberfläche einer Probe (P) gerichtet ist und aus der Untersuchung des reflektierten Ausfallstrahles (24) Hinweise auf Probeneigenschaften, bevorzugt auf Schichtdicken, gewonnen werden, und mit einer Einrichtung zur Ermittlung und Korrektur von Richtungsabweichungen zwischen einer Normalen auf die Probenoberfläche und einer Winkelhalbierenden (25) zwischen Ein- und Ausfallstrahl (23, 24), wobei ein Richtungskontrollstrahl (30) im wesentlichen in Richtung der Winkelhalbierenden (25) auf den Messort (M) gerichtet ist, dass ein Flächendetektor einen Rückreflex des Richtungskontrollstrahls (30) empfängt, wobei der Flächendetektor mit einer Auswerteschaltung (46) in Verbindung steht und wobei die Auswerteschaltung (46) mehrere Ausgänge aufweist, und dass an den Ausgängen der Auswerteschaltung (46) Stellbefehle für ein Stellsystem (47,47a) verfügbar sind, durch das eine Verkippung des Probentisches (12), auf dem die Probe (P) aufliegt, veranlasst wird, bis die Position des Rückreflexes auf dem Flächendetektor der vorgegebenen Position entspricht, bei der die Richtung der Normalen auf die Probenoberfläche mit der Richtung der Winkelhalbierenden (25) übereinstimmt **dadurch gekennzeichnet,**
optische Mittel zur Abbildung-des-Rückreflexes des Richtungskontrollstrahles (30) auf einen positionsempfindlichen Flächendetektor vorgesehen sind, wobei mindestens ein optisches Mittel im nicht benutzten freien Aperturraum eines Spiegelobjektivs (11) vorgesehen ist.

2. Optische Meßanordnung nach Anspruch 1, **dadurch gekennzeichnet, dass** als Flächendetektor ein Vier-Quadrantendetektor (39) vorgesehen ist, wobei die vom Rückreflex auf jeden Quadranten treffenden Lichtmengen als Auswertekriterien dienen und die Verkippung des Probentisches (12), auf dem die Probe (P) aufliegt, so lange veranlasst wird, bis auf alle vier Quadranten die gleichen Lichtmengen treffen.

3. Optische Meßanordnung nach Anspruch 1 oder 2, **dadurch gekennzeichnet, dass** als Quelle für den Richtungskontrollstrahl (30) ein fokussierbarer Diodenlaser (33), bevorzugt mit der Wellenlänge λ = 670nm, vorgesehen ist und im Strahlengang zwischen dem Diodenlaser (33) und der Oberfläche der Probe (P) ein Polarisationsteiler (35) und eine dem Polarisationsteiler (35) nachgeordnete λ/4-Platte (36) vorhanden ist, wobei der Rückreflex des Richtungskontrollstrahles (30) von der Teilerfläche des Polarisationsteilers (35) auf den Vier-Quadrantensensor (39) gelenkt ist.

4. Optische Meßanordnung nach dem Oberbegriff des Anspruchs 1, jedoch weiterhin mit einem Spektralphotometer, bei dem ein Probenmeßstrahl (7) durch ein Spiegelobjektiv (11) hindurch, das einen von dem Probenmeßstrahl (7) nicht benutzten freien Aperturraum aufweist, auf die Probe (P) gerichtet ist und das von der Probe (P) in das Spiegelobjektiv (11) zurückreflektierte Licht einem Spektrographen (9) zur Auswertung zugeführt wird, **dadurch gekennzeichnet, daß** optische Mittel zur Führung des Richtungskontrollstrahles (30) in einem nicht benutzten freien Aperturraum des Spiegelobjektivs (11) vorgesehen sind.

5. Optische Meßanordnung nach Anspruch 4, **dadurch gekennzeichnet, dass** das optische Mittel im nicht benutzten freien Aperturraum des Spiegelobjektivs (11) ein Umlenkspiegel (38) ist, von dem der Richtungskontrollstrahl (30) auf den Meßort (M) gerichtet ist, wobei der Probenmessstrahl (7) als ein vom Spiegelobjektiv (11) ausgehender Stahlenhohlkegel (40) ausgebildet ist, dessen Kegelspitze im Messort (M) liegt, und der Richtungskontrollstrahl (30) innerhalb des Stahlenhohlkegels (40) verläuft.

6. Meßanordnung bestehend aus einem Spiegelobjektiv (11) mit einem Zentralspiegel (41), der einen Schattenbereich (41a) festlegt, wobei das Spiegelobjektiv (11) einen Messort (M) auf einer Probe (P) beleuchtet und abbildet, und einer Nivelliereinrichtung (29) mit einer optischen Strahlungsquelle (33), einem Richtungskontrollstrahl (30) und einem ortsauflösenden Detektor (39), **dadurch gekennzeichnet, dass** mindestens ein optisches Mittel (38) im Schattenbereich (41a) des Zentralspiegels (41) des Spiegelobjektivs (11) angeordnet ist und den Richtungskontrollstrahl (30) im wesentlichen entlang der optischen Achse (32) des Spiegelobjektivs (11) führt und auf den Messort (M) der Probe (P) richtet, und daß das optische Mittel (38) den vom Messort (M) reflektierten Richtungskontrollstrahl (30) auf den Detektor (39) richtet.

7. Meßanordnung nach Anspruch 6, **dadurch gekennzeichnet, dass** das optische Mittel (38) derart angeordnet ist, dass der Richtungskontrollstrahl (30) parallel zur optischen Achse (32) des Spiegelobjektivs (11) ausgerichtet ist und dass ein Strahlenteiler (35) zum Auskoppeln und zur Ausrichtung des vom Messort (M) reflektierten Richtungskontrollstrahls (30) auf den Detektor (39) vorgesehen ist.

8. Meßanordnung nach Anspruch 6, **dadurch gekennzeichnet, dass** das optische Mittel (38) derart angeordnet ist, dass der auf den Messort (M) gerichtete und der vom Messort (M) reflektierte Richtungskontrollstrahl (30) zur optischen Achse (32) des Spiegelobjektivs (11) etwas geneigt sind.

9. Meßanordnung nach einem der Ansprüche 6 bis 8, **dadurch gekennzeichnet, dass** eine Auswerteschaltung (46) zur Auswertung der Detektorsignale und ein Stellsystem (47,47a) zur Veränderung der Neigung der Probe (P) vorgesehen sind, die die Neigungsabweichung der Senkrechten auf dem Messort (M) von der optischen Achse (32) auf einen bestimmten Wert regeln.

10. Verfahren zur Messung der Neigung eines von einem Objektiv (11) abgebildeten Messortes (M) auf einer Probe (P), **gekennzeichnet durch** folgende Schritte:
- Erzeugung eines Richtungskontrollstrahls (30) **durch** eine Strahlungsquelle (33),
- Führung des Richtungskontrollstrahls (30) zur optischen Achse (32) des Objektivs (11) hin, wobei der Richtungskontrollstrahl (30) in einen Bereich zwischen dem Objektiv (11) und dem Messort (M) gelangt,
- Umlenkung des Richtungskontrollstrahls (30) in die Richtung des Messortes (M),
- Reflexion des Richtungskontrollstrahls (30) am Messort (M),
- Umlenkung des reflektierten Richtungskontrollstrahls (30) aus der Nähe der optischen Achse (32) weg und zwar in einem Bereich zwischen dem Objektiv (11) und dem Messort (M), wobei die Umlenkung mit einem optischen Mittel erfolgt, das im nicht benutzten freien Aperturraum eines Spiegelobjektivs (11) vorgesehen ist
- Empfang des reflektierten Richtungskontrollstrahls (30) **durch** einen ortsauflösenden Detektor (39)
- Ermittlung der Neigungsabweichung der Senkrechten auf dem Messort (M) von der optischen Achse (32) des Objektivs (11) aus den Signalen des Detektors (39).

11. Verfahren nach Anspruch 10, **gekennzeichnet durch** den parallelen Verlauf des Richtungskontrollstrahls (30) zur optischen Achse (32) des Objektivs (11) im Bereich zwischen Objektiv (11) und Meßort (M).

12. Verfahren nach Anspruch 10, **gekennzeichnet durch** den Verlauf des Richtungskontrollstrahls (30) mit einer geringen Neigung gegen die optische Achse (32) des Objektivs (11) im Bereich zwischen Objektiv (11) und Meßort (M).

13. Verfahren nach einem der Ansprüche 10 bis 12, **dadurch gekennzeichnet, daß** das Spiegelobjektiv einen Zentralspiegel (41) umfasst und der Zentralspiegel (41) einen Schattenbereich (41a) definiert, wobei die Umlenkung des Richtungskontrollstrahls (30) im Schattenbereich (41 a) des Zentralspiegels (41) des Spiegelobjektivs erfolgt.

14. Verfahren nach einem der Ansprüche 10 bis 13, **gekennzeichnet durch** die folgenden Schritte:
- Auswerten der Signale des Detektors (39) mittels einer Auswerteschaltung (46) und
- Einstellen der Neigung der Probe (P) **durch** ein Stellsystem (47,47a) derart, dass ein vorgegebener Winkel zwischen der Senkrechten auf dem Messort (M) der Probe (P) und der optischen Achse (32) des Objektivs (11) geregelt wird.

15. Verfahren nach einem der Ansprüche 10 bis 13, **gekennzeichnet durch** die folgenden Schritte:
- Auswerten der Signale des Detektors (39) mittels einer Auswerteschaltung (46) und
- Einstellen der Neigung der Probe (P) **durch** ein Stellsystem (47,47a) derart, dass die optische Achse (32) des Objektivs (11) auf dem Messort (M) senkrecht steht.

## Claims

1. Optical measuring arrangement having an ellipsometer (45) in which an incident beam (23) with polarized light is directed at an angle α#90° onto a measurement site (M) on the surface of a sample (P), and indications of sample properties, preferably of layer thicknesses, are obtained from examining the reflected exit beam (24), and having a device for determining and correcting directional deviations between a normal to the sample surface and an angle bisector (25) between entrance beam (23) and exit beam (24), a direction control beam (30) being directed onto the measurement site (M) substantially in the direction of the angle bisector (25) in such a way that a surface detector receives a retroreflected direction control beam (30), the surface detector being connected to an evaluation circuit (46), and the evaluation circuit (46) having a number of outputs, and there being available at the outputs of the evaluation circuit (46) positioning commands of a positioning system (47, 47a) which causes the sample stage (12) on which the sample (P) rests to tilt until the position of the retroreflected beam on the surface detector corresponds to the prescribed position for which the direction of the normal to the sample surface coincides with the direction of the angle bisector (25), **characterized in that** optical means are provided for projecting the retroreflected direction control beam (30) onto a position-sensitive surface detector, at least one optical means being provided in the unused, free aperture space of a reflecting objective (11).

2. Optical measuring arrangement according to Claim 1, **characterized in that** a four-quadrant detector (39) is provided as surface detector, the light quantities from the retroreflected beam which strike each quadrant serving as evaluation criteria, and the sample stage (12) on which the sample (P) rests being caused to tilt until the same light quantities strike all four quadrants.

3. Optical measuring arrangement according to Claim 1 or 2, **characterized in that** a focusable diode laser (33), preferably with the wavelength λ = 670 nm, is provided as source for the direction control beam (30), and a polarization splitter (35) and a λ/4 plate (36) downstream of the polarization splitter (35) being present in the beam path between the diode laser (33) and the surface of the sample (P), the retroreflected direction control beam (30) being directed from the divider surface of the polarization splitter (35) onto the four-quadrant sensor.

4. Optical measuring arrangement according to the preamble of Claim 1, but further having a spectral photometer in the case of which a sample measuring beam (7) is directed onto the sample (P) through a reflecting objective (11) which has a free aperture space not used by the sample measuring beam (7), and the light retroreflected from the sample (P) into the reflecting objective (11) is fed to a spectrograph (9) for evaluation, **characterized in that** optical means are provided for guiding the direction control beam (30) in an unused free aperture space of the reflecting objective (11).

5. Optical measuring arrangement according to Claim 4, **characterized in that** the optical means in the unused free aperture space of the reflecting objective (11) is a deflecting mirror (38) from which the direction control beam (30) is directed onto the measurement site (M), the sample measuring beam (7) being designed as a hollow beam cone (40) emanating from the reflecting objective (11) and whose cone apex lies at the measurement site (M), and the direction control beam (30) runs inside the hollow beam cone (40).

6. Measuring arrangement comprising a reflecting objective (11) with a central mirror (41) which defines a shadow region (41a), the reflecting objective (11) illuminating and imaging a measurement site (M) on a sample (P), and a levelling device (29) having an optical radiation source (33), a direction control beam (30) and a spatially resolving detector (39), **characterized in that** at least one optical means (38) is arranged in the shadow region (41a) of the central mirror (41) of the reflecting objective (11), and guides the direction control beam (30) substantially along the optical axis (32) of the reflecting objective (11) and directs it onto the measurement site (M) of the sample (P), and **in that** the optical means (38) directs the direction control beam (30) reflected from the measurement site (M) onto the detector (39).

7. Measuring arrangement according to Claim 6, **characterized in that** the optical means (38) is arranged in such a way that the direction control beam (30) is aligned parallel to the optical axis (32) of the reflecting objective (11), and **in that** a beam splitter (35) is provided for coupling out the direction control beam (30) reflected from the measurement site (M) and directing it onto the detector (39).

8. Measuring arrangement according to Claim 6, **characterized in that** the optical means (38) is arranged in such a way that the direction control beam (30) directed onto the measurement site (M), and the direction control beam (30) reflected from the measurement site (M) are somewhat inclined to the optical axis (32) of the reflecting objective (11).

9. Measuring arrangement according to one of Claims 6 to 8, **characterized in that** an evaluation circuit (46) for evaluating the detector signals, and a positioning system (47, 47a) for changing the inclination of the sample (P) are provided and regulate the deviation in inclination of the perpendicular to the measurement site (M) from the optical axis (32) to a specific value.

10. Method for measuring the inclination of a measurement site (M) projected by an objective (11), **characterized by** the following steps:
- producing a direction control beam (30) by means of a radiation source (33),
- guiding the direction control beam (30) towards the optical axis (32) of the objective (11), the direction control beam (30) passing into a region between the objective (11) and the measurement site (M),
- deflecting the direction control beam (30) in the direction of the measurement site (M),
- reflecting the direction control beam (30) at the measurement site (M),
- deflecting the reflected direction control beam (30) away from the vicinity of the optical axis (32), specifically in a region between the objective (11) and the measurement site (M), the deflection being performed with the aid of an optical means which is provided in the unused free aperture space of a reflecting objective (11),
- receiving the reflected direction control beam (30) by means of a spatially resolving detector (39), and
- determining the deviation in inclination of the perpendicular to the measurement site (M) from the optical axis (32) of the objective (11) from the signals of the detector (39).

11. Method according to Claim 10, **characterized by** the parallel course of the direction control beam (30) relative to the optical axis (32) of the objective (11) in the region between the objective (11) and measurement site (M).

12. Method according to Claim 10, **characterized by** the course of the direction control beam (30) with a slight inclination to the optical axis (32) of the objective (11) in the region between the objective (11) and measurement site (M).

13. Method according to one of Claims 10 to 12, **characterized in that** the deflecting objective comprises a central mirror (41) and the central mirror (41) defines a shadow region (41a), the deflection of the direction control beam (30) taking place in the shadow region (41a) of the central mirror (41) of the reflecting objective.

14. Method according to one of Claims 10 to 13, **characterized by** the following steps:
- evaluating the signals of the detector (39) by means of an evaluation circuit (46), and
- setting the inclination of the sample (P) by means of a positioning system (47, 47a) in such a way that a predetermined angle is regulated between the perpendicular to the measurement site (M) of the sample (P) and the optical axis (32) of the objective (11).

15. Method according to one of Claims 10 to 13, **characterized by** the following steps:
- evaluating the signals of the detector (39) by means of an evaluation circuit (46), and
- setting the inclination of the sample (P) by means of a positioning system (47, 47a) in such a way that the optical axis (32) of the objective (11) is perpendicular to the measurement site (M).

## Revendications

1. Arrangement de mesure optique comprenant un ellipsomètre (45) avec lequel un rayon incident (23) de lumière polarisée est dirigé sous un angle α ≠ 90° sur un point de mesure (M) sur la surface d'un échantillon (P) et à partir de l'analyse du rayon sortant (24) sont obtenues des informations sur les propriétés de l'échantillon, de préférence sur les épaisseurs de couche, et comprenant un dispositif pour déterminer et corriger les écarts de direction entre une normale sur la surface de l'échantillon et une bissectrice (25) entre le rayon incident et le rayon sortant (23, 24), un rayon de contrôle de la direction (30) étant dirigé pour l'essentiel dans la direction de la bissectrice (25) sur le point de mesure (M), tel qu'un détecteur superficiel reçoit une rétroréflexion du rayon de contrôle de la direction (30), le détecteur superficiel étant en liaison avec un circuit d'évaluation (46), et tel que des instructions de positionnement pour un système de positionnement (47, 47a) sont disponibles aux sorties du circuit d'évaluation (46) par le biais desquelles est ordonné un basculement de la table à échantillon (12) sur laquelle repose l'échantillon (P) jusqu'à ce que la position de la rétroréflexion sur le détecteur superficiel corresponde à la position prédéfinie à laquelle la direction de la normale sur la surface de l'échantillon coïncide avec la direction de la bissectrice (25), **caractérisé par** des moyens optiques prévus pour représenter la rétroréflexion du rayon de contrôle de direction (30) sur un détecteur superficiel sensible à la position, au moins un moyen optique étant prévu dans l'espace d'ouverture libre non utilisé d'un objectif à miroir (11).

2. Arrangement de mesure optique selon la revendication 1, **caractérisé en ce que** le détecteur superficiel prévu est un détecteur à quatre quadrants (39), les quantités de lumière de la rétroréflexion qui viennent frapper chaque quadrant servant de critères d'évaluation et le basculement de la table à échantillon (12) sur laquelle repose l'échantillon (P) étant ordonné jusqu'à ce que la même quantité de lumière vienne frapper les quatre quadrants.

3. Arrangement de mesure optique selon la revendication 1 ou 2, **caractérisé en ce que** la source prévue pour le rayon de contrôle de direction (30) est un laser à diode (33) focalisable, de préférence ayant une longueur d'onde λ = 670 nm, et dans le trajet du rayon entre le laser à diode (33) et la surface de l'échantillon (P) se trouve un diviseur à polarisation (35) et une plaque λ/4 (36) disposée à la suite du diviseur à polarisation (35), la rétroréflexion du rayon de contrôle de la direction (30) étant déviée de la surface partielle du diviseur à polarisation (35) sur le capteur à quatre quadrants (39).

4. Arrangement de mesure optique selon le préambule de la revendication 1, mais comprenant en plus un photomètre spectral avec lequel un rayon de mesure d'échantillon (7) est dirigé sur l'échantillon (P) à travers un objectif à miroir (11) qui présente un espace d'ouverture libre non utilisé par le rayon de mesure d'échantillon (7) et la lumière réfléchie par l'échantillon (P) dans l'objectif à miroir (11) est acheminée à un spectrographe (9) pour y être évaluée, **caractérisé en ce que** sont prévus des moyens optiques pour guider le rayon de contrôle de la direction (30) dans un espace d'ouverture libre non utilisé de l'objectif à miroir (11).

5. Arrangement de mesure optique selon la revendication 4, **caractérisé en ce que** le moyen optique dans l'espace d'ouverture libre non utilisé de l'objectif à miroir (11) est un miroir de déviation (38) par lequel le rayon de contrôle de la direction (30) est dirigé sur le point de mesure (M), le rayon de mesure de l'échantillon (7) étant réalisé sous la forme d'un cône creux de rayons (40) émanant de l'objectif à miroir (11) dont la pointe du cône se trouve dans le point de mesure (M) et le rayon de contrôle de la direction (30) s'étendant à l'intérieur du cône creux de rayons (40).

6. Arrangement de mesure composé d'un objectif à miroir (11) comprenant un miroir central (41) qui détermine une zone d'ombré (41a), l'objectif à miroir (11) éclairant et représentant un point de mesure (M) sur un échantillon (P), et un dispositif de mise à niveau (29) comprenant une source de rayonnement optique (33), un rayon de contrôle de la direction (30) et un détecteur de localisation (39), **caractérisé en ce qu'**au moins un moyen optique (38) est disposé dans la zone d'ombre (41a) du miroir central (41) de l'objectif à miroir (11) et le rayon de contrôle de la direction (30) se propage pour l'essentiel le long de l'axe optique (32) de l'objectif à miroir (11) et est dirigé sur le point de mesure (M) de l'échantillon (P), et que le moyen optique (38) dirige sur le détecteur (39) le rayon de contrôle de la direction (30) réfléchi par le point de mesure (M).

7. Arrangement de mesure selon la revendication 6, **caractérisé en ce que** le moyen optique (38) est disposé de telle sorte que le rayon de contrôle de la direction (30) est dirigé parallèlement à l'axe optique (32) de l'objectif à miroir (11) et qu'il est prévu un diviseur de rayon (35) pour découpler et pour aligner sur le détecteur (39) le rayon de contrôle de la direction (30) réfléchi par le point de mesure (M).

8. Arrangement de mesure selon la revendication 6, **caractérisé en ce que** le moyen optique (38) est disposé de telle sorte que le rayon de contrôle de la direction (30) dirigé sur le point de mesure (M) et réfléchi par le point de mesure (M) est légèrement incliné par rapport à l'axe optique (32) de l'objectif à miroir (11).

9. Arrangement de mesure selon l'une des revendications 6 à 8, **caractérisé en ce qu'**il est prévu un circuit d'évaluation (46) pour évaluer les signaux de détecteur et un système de positionnement (47, 47a) pour modifier l'inclinaison de l'échantillon (P), lesquels régulent l'écart d'inclinaison de la verticale sur le point de mesure (M) par rapport à l'axe optique (32) à une valeur donnée.

10. Procédé de mesure de l'inclinaison d'un point de mesure (M) représenté par un objectif (11) sur un échantillon (P), **caractérisé par** les étapes suivantes :
- production d'un rayon de contrôle de la direction (30) par une source de rayonnement (33),
- acheminement du rayon de contrôle de la direction (30) vers l'axe optique (32) de l'objectif (11), le rayon de contrôle de la direction (30) arrivant dans une zone entre l'objectif (11) et le point de mesure (M),
- déviation du rayon de contrôle de la direction (30) dans la direction du point de mesure (M),
- réflexion du rayon de contrôle de la direction (30) au niveau du point de mesure (M),
- déviation du rayon de contrôle de la direction (30) réfléchi hors de la proximité de l'axe optique (32), et ce dans une zone entre l'objectif (11) et le point de mesure (M), la déviation étant réalisée avec un moyen optique qui est prévu dans l'espace d'ouverture libre non utilisé d'un objectif à miroir (11),
- réception du rayon de contrôle de la direction (30) par un détecteur de localisation (39),
- détermination de l'écart d'inclinaison de la verticale sur le point de mesure (M) par rapport à l'axe optique (32) de l'objectif (11) à partir des signaux du détecteur (39).

11. Procédé selon la revendication 10, **caractérisé par** le tracé parallèle du rayon de contrôle de la direction (30) vers l'axe optique (32) de l'objectif (11) dans la zone entre l'objectif (11) et le point de mesure (M).

12. Procédé selon la revendication 10, **caractérisé par** le tracé du rayon de contrôle de la direction (30) avec une faible inclinaison vers l'axe optique (32) de l'objectif (11) dans la zone entre l'objectif (11) et le point de mesure (M).

13. Procédé selon l'une des revendications 10 à 12, **caractérisé en ce que** l'objectif à miroir comprend un miroir central (41) et le miroir central (41) définit une zone d'ombre (41a), la déviation du rayon de contrôle de la direction (30) s'effectuant dans la zone d'ombre (41a) du miroir central (41) de l'objectif à miroir.

14. Procédé selon l'une des revendications 10 à 13, **caractérisé par** les étapes suivantes :
- évaluation des signaux du détecteur (39) au moyen d'un circuit d'évaluation (46) et
- réglage de l'inclinaison de l'échantillon (P) par un système de positionnement (47, 47a) de manière à régler un angle prédéfini entre la verticale sur le point de mesure (M) de l'échantillon (P) et l'axe optique (32) de l'objectif (11).

15. Procédé selon l'une des revendications 10 à 13, **caractérisé par** les étapes suivantes :
- évaluation des signaux du détecteur (39) au moyen d'un circuit d'évaluation (46) et
- réglage de l'inclinaison de l'échantillon (P) par un système de positionnement (47, 47a) de telle sorte que l'axe optique (32) de l'objectif (11) est vertical sur le point de mesure (M).
